(19) Europäisches Patentamt
European Patent Office
Office européen des brevets

(11) EP 0 553 028 B1

(12) **FASCICULE DE BREVET EUROPEEN**

(45) Date de publication et mention
de la délivrance du brevet:
**29.04.1998 Bulletin 1998/18**

(51) Int Cl.⁶: **G01R 33/26**

(21) Numéro de dépôt: **93400141.3**

(22) Date de dépôt: **21.01.1993**

(54) **Magnétomètre à résonance et à pompage optique utilisant un laser monolithique**

Resonanz-Magnetometer mit optischen Pumpen, das einen monolithischen Laser verwendet

Resonance magnetometer with optical pumping using a monolithic laser

(84) Etats contractants désignés:
**BE DE GB IT NL SE**

(30) Priorité: **23.01.1992 FR 9200712**

(43) Date de publication de la demande:
**28.07.1993 Bulletin 1993/30**

(73) Titulaire: **COMMISSARIAT A L'ENERGIE ATOMIQUE**
**75015 Paris (FR)**

(72) Inventeur: **Leger, Jean-Michel**
**F-38240 Meylan (FR)**

(74) Mandataire: **Signore, Robert**
**c/o BREVATOME**
**25, rue de Ponthieu**
**75008 Paris (FR)**

(56) Documents cités:
**EP-A- 0 246 146**  **WO-A-91/05273**
**DE-A- 3 150 391**

- **JOURNAL OF APPLIED PHYSICS. vol. 68, no. 3, 1 Août 1990, NEW YORK US pages 943 - 949 L.D. SCHEARER ET AL. 'TUNABLE LASERS AT 1080 NM FOR HELIUM OPTICAL PUMPING'**
- **JOURNAL OF APPLIED PHYSICS. vol. 64, no. 12, 15 Décembre 1988, NEW YORK US pages 6615 - 6617 R.E. SLOCUM ET AL. 'ND:LNA LASER OPTICAL PUMPING OF 4HE: APPLICATION TO SPACE MAGNETOMETERS'**

## Description

### Domaine technique

La présente invention a pour objet un magnétomètre à résonance et à pompage optique utilisant un laser monolithique. Elle trouve une application dans la mesure précise des champs magnétiques faibles (typiquement dans la plage de 20 à 70 µT correspondant aux valeurs du champ magnétique terrestre).

### Etat de la technique antérieure

Le magnétomètre de l'invention entre dans la catégorie des magnétomètres dits à résonance, dont on pourra trouver une description générale dans l'article de F. HARTMAN intitulé "Resonance Magnetometers", publié dans la revue "IEEE Transactions on Magnetics", vol. MAG-8, n° 1, Mars 1972, pp. 66-75.

Un magnétomètre à résonance est un appareil qui, plongé dans un champ magnétique Bo, délivre un signal électrique de fréquence F dont la valeur est liée à Bo par la relation dite de LARMOR :

$$F = \gamma Bo$$

où $\gamma$ est un rapport gyromagnétique (d'un électron ou d'un nucléon selon la substance utilisée). Pour l'électron, par exemple, ce rapport est égal à 28Hz/nT.

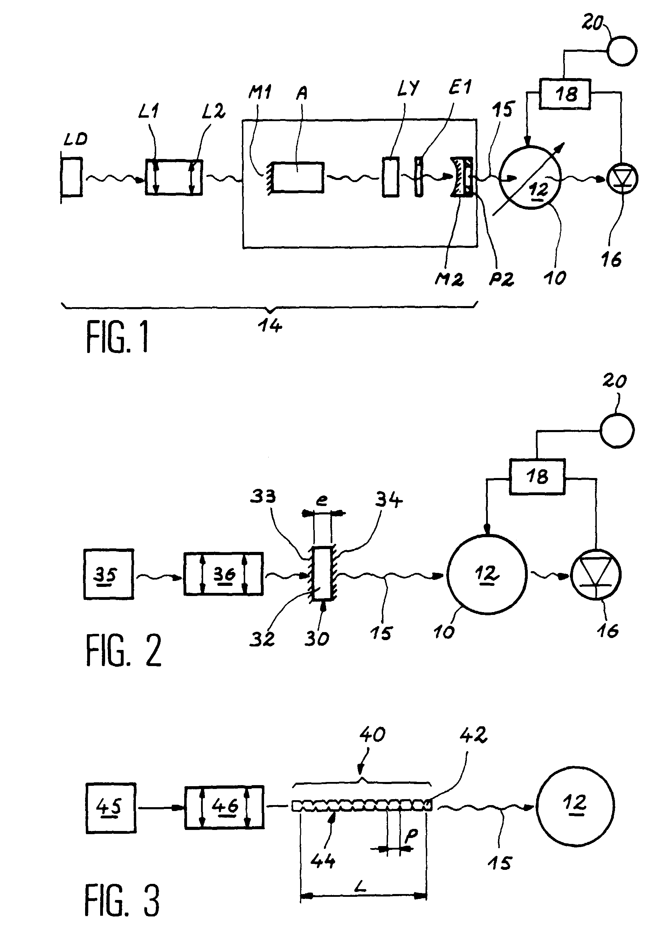

Dans cette classe d'appareils, le magnétomètre à pompage optique occupe une place privilégiée. La constitution générale d'un tel magnétomètre est représentée schématiquement sur la figure 1.

Une cellule 10, au moins partiellement transparente, est remplie d'un gaz 12, en général de l'hélium (isotope 4), à une pression de 1 à quelques torrs (1 torr = 133.322 Pa). Une source lumineuse 14 délivre un faisceau lumineux 15 dont la longueur d'onde se situe autour de 1,1 µm dans le cas de l'hélium. Ce faisceau est injecté dans la cellule 10.

Par ailleurs, une décharge radio-fréquence (dite "faible" ou "douce") est produite dans le gaz par des moyens appropriés non représentés. Cette décharge produit des atomes dans un état métastable ($2^3S_1$ dans le cas de l'hélium). Le faisceau lumineux incident 15 "pompe" ces atomes à partir de l'état métastable pour les amener dans un autre état excité ($2^3P$).

En présence d'un champ magnétique Bo, les niveaux d'énergie se séparent en sous-niveaux, dits de ZEEMAN. Une résonance radiofréquence entre de tels sous-niveaux peut être établie par un champ radiofréquence (résonance magnétique) ou par une modulation de la lumière (double résonance optique). Dans le cas de l'hélium et pour l'isotope 4, la résonance s'établit entre deux sous-niveaux électronique ZEEMAN de l'état métastable. Cette résonance est mise en évidence par divers moyens électroniques connus de l'homme du métier, schématisés sur la figure 1 par un photodétecteur 16, des moyens de traitement 18 et un moyen 20 pour mesurer la fréquence du signal électrique traité. La présente invention ne portant pas sur ces moyens, il est inutile de les décrire en détail. Tout moyen connu convient. On pourra se reporter, par exemple, à la série de quatre brevets déposés par le présent Demandeur, à savoir FR-A-2 663 429, FR-A-2 663 430, FR-A-2 663 431 et FR-A-2 663 432, qui décrivent diverses dispositions pouvant être utilisées pour mesurer la fréquence F.

La fréquence F étant mesurée, on en déduit immédiatement la valeur Bo du champ magnétique ambiant par la relation Bo = F/$\gamma$.

La source lumineuse servant dans ce genre d'application doit présenter des caractéristiques bien particulières.

En premier lieu, elle doit émettre à une longueur d'onde accordable autour de la transition $2^3S_1$-$2^3P$ de l'hélium. Cette longueur d'onde doit ensuite être stabilisée sur l'une des raies de cette transition, par exemple la raie Do dans le cas de l'isotope 4 de l'hélium.

Il importe, par ailleurs, que le laser utilisé pour constituer cette source n'émette qu'à cette unique longueur d'onde, car les modes de longueur d'onde différente de celle de la transition choisie entraîneraient une dégradation des performances du magnétomètre : augmentation du bruit d'amplitude du laser, apparition de bruit modal, éventuels décalages de fréquence de résonance du magnétomètre liés à des déplacements des niveaux d'énergie des atomes d'hélium sous l'effet de l'interaction optique non résonnante, diminution de l'efficacité du pompage optique, etc....

Toute l'énergie émise doit donc l'être dans le domaine de longueur d'onde correspondant à la transition choisie, ce qui correspond, par exemple, à une bande de fréquence de l'ordre de 2GHz à température ambiante pour la raie Do de l'hélium.

Enfin, la source doit être insensible à son environnement, tant thermique que mécanique.

Pour toutes ces raisons, on a remplacé les lampes traditionnelles à hélium par des lasers à solide pompés optiquement. On connaît ainsi, par le document FR-A-2 598 518 (ou son correspondant européen EP-A-0 246 146) un magnétomètre où le laser est un laser à LNA (aluminate de lanthane-néodyme). On peut se reporter également à l'article de L.D. SCHEARER et al., intitulé "Tunable Lasers at 1080 nm for Helium Optical Pumping" publié dans J. Appl. Phys. 68 (3), 1er Août 1990, pp. 943-949, ou encore à l'article de L.D. SCHEARER et al., intitulé "LNA : A New Cw Nd Laser Tunable Around 1.05 and 1.08 µm", publié dans IEEE J. of Quant. Electronics, vol. QE-22, n° 5, Mai 1986, pp. 713-717.

Dans ces techniques antérieures, le laser à solide utilisé est associé à de nombreux moyens, comme illustré schématiquement sur la figure 1. Dans l'exemple représenté, le laser à solide, qui est pompé optiquement par une source LD associée à une optique de formation et de focalisation L1, L2 comprend :

- un cristal A, constituant le milieu amplificateur ; ce cristal peut être par exemple en LNA et avoir environ 5 mm de long et 5 mm de diamètre ; des couches multidiélectriques (coefficient de réflexion supérieur à 99% à 1,08 µm et de transmission supérieur à 95% pour la lumère de pompage) sont déposées sur la face avant de ce cristal de sorte que celui-ci constitue également un miroir d'entrée M1 de la cavité laser ;
- un miroir de sortie M2 ; un traitement dichroïque de ce miroir permet de forcer l'émission du laser sur la bande centrée autour de 1,03 µm ; le spectre de fluorescence du LNA présente en effet deux bandes autour de 1 µm, la plus intense étant située aux environs de 1,054 µm ; le traitement multidiélectrique retenu (transmission de 50% pour $\lambda = 1,05$ µm et transmission d'environ 1,5% pour $\lambda = 1,08$ µm) permet d'empêcher le laser d'osciller spontanément au voisinage de la longueur d'onde de la bande principale de fluorescence ; on peut également utiliser un filtre de LYOT, qui est référencé LY sur la figure ;
- un ou plusieurs étalons solides E1, de type FABRY-PEROT, d'épaisseur quelques centaines de microns (150 µm et 200 µm par exemple), insérés dans la cavité ; ces étalons FABRY-PEROT jouent le rôle d'éléments sélectifs en longueur d'onde ; le contrôle de leur épaisseur et/ou de leur inclinaison (c'est-à-dire le contrôle de la longueur optique à laquelle ils correspondent) permet l'accord en longueur d'onde du laser ;
- enfin, pour accorder finement cette longueur d'onde émise, une cale piézoélectrique P2 équipe la monture du miroir de sortie M2 de la cavité ; on peut alors faire varier légèrement la longueur de cette cavité et faire coïncider la longueur d'onde du laser avec le centre de la raie d'absorption retenue (par exemple la raie Do) ; c'est par cet intermédiaire qu'est en général effectué l'asservissement en longueur d'onde du laser à partir d'une mesure de fluorescence d'une cellule d'hélium.

Dans d'autres réalisations, décrites notamment dans l'article de L.D. SCHEARER et al., déjà cité, le cristal constituant le milieu amplificateur peut être remplacé par une fibre optique dopée au néodyme. La structure générale du dispositif reste identique à celle qui a été décrite ci-dessus dans le cas du laser LNA.

L'inconvénient majeur de ces magnétomètres tient aux difficultés rencontrées pour stabiliser la longueur d'onde d'émission du laser. Cette dernière est en effet déterminée par un ensemble d'éléments, à savoir :

- la longueur totale de la cavité (qui fixe la place des modes de la cavité),
- la longueur du milieu amplificateur (cristal, ou fibre dopée) qui constitue souvent un résonateur FABRY-PEROT donnant lieu à un effet étalon parasite,
- l'épaisseur et l'inclinaison des éléments sélectifs (E1, LY).

Pour obtenir l'effet laser sur la transition souhaitée, il convient que tous ces paramètres soient simultanément ajustés, la variation de l'un quelconque d'entre eux se traduisant immédiatement par une variation de la longueur d'onde émise par le laser et une dégradation des performances du magnétomètre.

De ce fait, les magnétomètres utilisant de tels lasers sont très sensibles à l'environnement, notamment aux vibrations mécaniques ou aux variations thermiques. Une variation de température se traduit en effet par une dilatation ou un retrait des matériaux, ce qui a pour conséquence de décaler la longueur d'onde. Ainsi, par exemple, pour le cristal de LNA, une variation $\Delta T$ de température se traduit par une variation de l'indice d'environ $2,1 \cdot 10^{-5} \Delta T$.

Il en va de même pour la lame FABRY-PEROT, ces deux paramètres modifiant, qui plus est, la longueur totale de la cavité. En pratique, cela se traduit finalement par la nécessité de contrôler la température des différents éléments de la cavité avec une précision de l'ordre de quelques centièmes de degré.

De même, il est indispensable d'asservir la longueur totale de la cavité, par déplacement du miroir de sortie.

On peut noter enfin que de tels lasers sont d'un coût de revient élevé, supérieur à 100 kF en l'état actuel de l'art.

**Exposé de l'invention**

Le but de l'invention est justement d'éviter ces inconvénients. A cette fin, l'invention propose d'utiliser, pour constituer le laser, une structure monolithique, c'est-à-dire un élément solide unique remplissant à la fois les fonctions d'amplification et de sélection en longueur d'onde.

Dans une première variante, l'élément solide unique est un cristal amplificateur dont les deux faces sont recouvertes de couches réfléchissantes et dont l'épaisseur est telle que le laser oscille sur un seul mode longitudinal avec une longueur d'onde apte à pomper optiquement le gaz de la cellule.

Dans ce cas, la bande de fluorescence du cristal doit contenir la longueur d'onde de la transition retenue pour le pompage optique du gaz (par exemple $\lambda o = 10829,081$ Å correspondant à la raie Do de l'hélium). La lumière de pompage optique est focalisée sur le cristal dont l'épaisseur est telle que le laser soit, par construction, monomode longitudinal. Cette épaisseur varie en fonction de la plage de longueur d'onde autour de laquelle le cristal est susceptible de fonctionner. Plus cette dernière est importante, plus le cristal doit être fin. Les miroirs de la cavité sont directement déposés sur ce cristal, dont seule la longueur détermine la longueur d'onde émise. Par exemple, dans le cas de l'utilisation d'un cristal de LNA, la face d'entrée sert de support à un traitement de couches multidiélectriques, pour produire un coefficient de réflexion supérieur à 99% à 1,08 µm et un coefficient de transmission supérieur à 95% pour la longueur d'onde du pompage optique ; le traitement de la face de sortie est tel que le coefficient de transmission soit supérieur à 50% pour 1,05 µm et d'environ quelques pourcents pour 1,08 µm.

Dans un second mode de réalisation, l'élément solide unique est une fibre optique amplificatrice, cette fibre étant gravée sur une partie au moins de sa longueur par un réseau de diffraction avec un pas et une longueur tels que le laser oscille sur une longueur d'onde apte à pomper optiquement le gaz de la cellule.

Le réseau peut être gravé sur la fibre selon la technique décrite dans l'article de M. DOUAY et al., intitulé "Formation of Bragg Gratings in Germanium Doped Optical Fibers Using a Prism Interferometer", publié dans le Journal de Physique, 4, (1991).

Alors que dans le premier mode de réalisation, le paramètre unique à contrôler pour s'assurer que le laser émette à la longueur souhaitée était la longueur du cristal, il faut, dans ce second mode de réalisation, maîtriser le pas du réseau pour contrôler la longueur d'onde émise par le laser, la longueur du réseau déterminant la largeur des modes émis.

Quel que soit le mode de réalisation mis en oeuvre, le recours à un élément solide unique permet de remédier à tous les inconvénients de l'art antérieur notés plus haut.

On peut observer que, pour éviter ces inconvénients, une autre solution pouvait être retenue qui consiste à utiliser un laser à semiconducteur comme décrit dans le document US-A-5,036,278 et non un laser à solide pompé par une source annexe. Mais le recours à un tel type de laser entraîne d'autres inconvénients, comme la faiblesse de l'intensité lumineuse émise et la fluctuation de longueur d'onde en fonction du courant d'alimentation.

## Brève description des dessins

- La figure 1, déjà décrite, montre un magnétomètre selon l'art antérieur ;
- la figure 2 illustre un premier mode de réalisation de l'invention ;
- la figure 3 illustre un deuxième mode de réalisation de l'invention ;
- la figure 4 montre un moyen thermique de modulation de la longueur d'onde ;
- la figure 5 montre un moyen piézoélectrique de modulation de la longueur d'onde dans le cas du premier mode de réalisation ; et
- la figure 6 montre un moyen piézoélectrique de modulation de la longueur d'onde dans le cas du second mode de réalisation.

## Exposé détaillé d'un mode de réalisation

On voit, sur la figure 2, un magnétomètre conforme à l'invention avec des moyens 10, 12, 15, 16, 18, 20 aptes à déterminer la fréquence de LARMOR, moyens déjà évoqués à propos de la figure 1 ; conformément à l'invention le magnétomètre comprend un ensemble monolithique 30 comprenant un cristal 32 d'épaisseur e avec deux faces 33 et 34 convenablement traitées pour présenter les coefficients de réflexion et de transmission requis, comme expliqué plus haut. L'ensemble 30 est excité par une source de pompage 35 dont le faisceau est éventuellement mis en forme par un ensemble 36 (comprenant notamment des lentilles de focalisation et éventuellement un anamorphoseur).

La figure 3 montre un magnétomètre selon un deuxième mode de réalisation dans lequel l'ensemble monolithique 40 est constitué d'une fibre optique 42 dont une partie au moins de la surface est gravée par un réseau 44 de pas p et de longueur L. La fibre est encore pompée par une source de pompage 45 associée à un moyen de mise en forme et de focalisation 46.

Quel que soit le mode de réalisation choisi, il peut être utile d'asservir la longueur d'onde émise par le laser à une valeur de consigne correspondant au pic d'absorption du gaz utilisé. Pour cela, et selon une technique connue en matière de lasers stabilisés en fréquence, on module à basse fréquence la longueur d'onde émise, on détecte les effets de cette modulation par exemple sur la fluorescence du gaz et on corrige la longueur d'onde émise pour la ramener à une valeur de consigne.

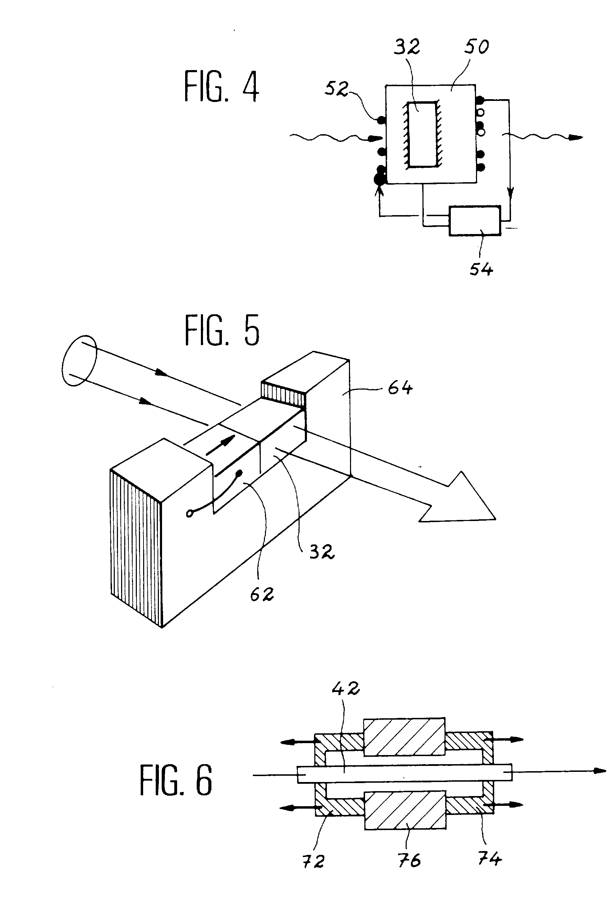

Pour moduler la longueur d'onde, trois moyens peuvent être utilisés qui sont illustrés sur les figures 4, 5 et 6.

Sur la figure 4, tout d'abord, ces moyens consistent en une enceinte thermostatée 50 munie d'un enroulement chauffant 52 alimenté par une source de courant 54. Dans cette variante, la modification de longueur d'onde résulte d'une variation d'épaisseur du cristal 32.

La figure 5 illustre un montage différent, de type piézoélectrique, où le cristal 32 est pris entre un barreau piézoélectrique 62 et une butée 64, selon une disposition décrite dans l'article de J.J. ZAYHOWSKI et al., intitulé "Frequency-modulated Nd : YAG microchip Lasers", publié dans Optics Letters, vol. 14, n° 12, 15 Juin 1989, pp. 618-620.

Enfin, la figure 6, relative à la variante à fibre, montre deux barreaux piézoélectriques 72, 74 avec une cale 76, l'ensemble permettant d'allonger la fibre 42 ou de la relâcher et de modifier ainsi sa longueur d'onde de fonctionnement par modification du pas du réseau.

## Revendications

1. Magnétomètre à résonance et à pompage optique comprenant une cellule (10) remplie d'un gaz (12) dont les atomes présentent un rapport gyromagnétique $\gamma$, un laser à solide (14) comprenant un milieu amplificateur (A) pompé optiquement par une source de lumière (LD, 35, 45) et des moyens de sélection en longueur d'onde pour faire émettre à ce laser un faisceau lumineux apte à pomper optiquement le gaz (12) de la cellule (10), des moyens de traitement (16, 18, 20) d'un signal électrique de résonance à une fréquence de LARMOR F=γBo où Bo est un champ magnétique ambiant dans lequel plonge la cellule (10) et qui est le champ à mesurer, l'amplitude du champ magnétique ambiant se déduisant de la fréquence F par la relation Bo=F/γ, ce magnétomètre étant caractérisé par le fait que le laser à solide comprend un élément solide unique (30, 40) remplissant à la fois la fonction d'amplification et celle de sélection en longueur d'onde.

2. Magnétomètre selon la revendication 1, caractérisé par le fait que l'élément unique (30) du laser à solide est un cristal amplificateur (32) dont les deux faces (33, 34) sont recouvertes de couches réfléchissantes et dont l'épaisseur (e) est telle que le laser oscille sur un seul mode longitudinal avec une longueur d'onde apte à pomper optiquement le gaz (12) de la cellule (10).

3. Magnétomètre selon la revendication 1, caractérisé par le fait que l'élément unique (40) du laser à solide est une fibre optique amplificatrice (42), cette fibre étant gravée sur une partie au moins de sa longueur par un réseau de diffraction (44) avec un pas (p) et une longueur (L) tels que le laser oscille sur une longueur d'onde apte à pomper optiquement le gaz (12) de la cellule (10).

4. Magnétomètre selon l'une quelconque des revendications 2 et 3, caractérisé par le fait que le laser comprend des moyens pour moduler à basse fréquence la longueur d'onde d'émission et des moyens pour asservir la longueur d'onde à une valeur de consigne.

5. Magnétomètre selon la revendication 4, caractérisé par le fait que les moyens pour moduler la longueur d'onde d'émission du laser sont constitués par des moyens (50, 52, 54) aptes à moduler la température de l'élément solide unique.

6. Magnétomètre selon la revendication 4, caractérisé par le fait que les moyens pour moduler la longueur d'onde d'émission sont constitués par des moyens (62, 64, 72, 74, 76) aptes à appliquer à l'élément solide unique des contraintes mécaniques en compression ou en traction.

**Patentansprüche**

1. Resonanz-Magnetometer mit optischem Pumpen, umfassend eine Zelle (10), gefüllt mit einem Gas (12), dessen Atome ein gyromagnetisches Verhältnis γ aufweisen,

einen Festkörperlaser (14) mit einem optisch durch eine Lichtquelle (LD, 35, 45) gepumpten Verstärkermedium (A) und mit Wellenlängen-Selektionseinrichtungen, um diesen Laser zu befähigen, einen Lichtstrahl zu emittieren, der das Gas (12) der Zelle (10) optisch pumpen kann,
Verarbeitungseinrichtungen (16, 18, 20) eines elektrischen Resonanzsignals mit einer LARMOR-Frequenz F= γ Bo, wo Bo ein magnetisches Umfeld bzw. Umgebungsfeld ist, in das die Zelle (10) eingetaucht ist und welches das zu messende Magnetfeld ist,
wobei die Amplitude des magnetischen Umfelds bzw. Umgebungsfelds sich durch die Relation Bo=F/γ von der Frequenz F ableitet,
wobei dieses Magnetometer **dadurch gekennzeichnet** ist, daß dieser Festkörperlaser ein einziges Festkörperelement (30, 40) umfaßt, das zugleich die Funktion der Verstärkung und die der Wellenlängenselektion erfüllt.

2. Magnetometer nach Anspruch 1, dadurch gekennzeichnet, daß das einzige Element (30) des Festkörperlasers ein Verstärkerkristall (32) ist, dessen beiden Seiten (33, 34) mit reflektierenden Schichten überzogen sind und dessen Dicke (e) derartig ist, daß der Laser in einer einzigen Longitudinalmode schwingt, mit einer Wellenlänge, die fähig ist, das Gas (12) der Zelle (10) zu pumpen.

3. Magnetometer nach Anspruch 1, dadurch gekennzeichnet, daß das einzige Element des Festkörperlasers (40) eine optische Verstärkungsfaser (42) ist, wobei diese Faser über wenigstens einen Teil ihrer Länge mit einem Beugungsgitter (44) mit einer Teilung (p) und eine Länge (L) geätzt ist, so daß der Laser über eine Wellenlänge schwingt, die das Gas (12) der Zelle (10) optisch pumpen kann.

4. Magnetometer nach einem der Ansprüche 2 und 3, dadurch gekennzeichnet, daß der Laser Einrichtungen umfaßt, um bei Niederfrequenz die Emissionswellenlänge zu modulieren, und Einrichtungen, um die Wellenlänge auf einen Sollwert zu regeln.

5. Magnetometer nach Anspruch 4, dadurch gekennzeichnet, daß die Einrichtungen zum Modulieren der Emissionswellenlänge des Lasers durch Einrichtungen (50, 52, 54) gebildet werden, die die Temperatur des einzigen Festkörperelements modulieren können.

6. Magnetometer nach Anspruch 4, dadurch gekennzeichnet, daß die Einrichtungen zum Modulieren der Emissionswellenlänge durch Einrichtungen (62, 64, 72, 74, 76) gebildet werden, die fähig sind, auf das einzige Festkörperelement mechanische Druck- und Zugkräfte auszuüben.

able to apply mechanical compressive or tensile stresses to the sole solid element.

## Claims

1. Resonance and optical pumping magnetometer including a cell (10) filled with a gas whose atoms exhibit a gyromagnetic ratio $\gamma$, a solid laser (14) including an amplifier medium (A) optically pumped by a light source (LD, 35, 45) and wavelength selection means for emitting to this laser a luminous beam able to optically pump the gas (12) of the cell (10), means (16, 18, 20) for processing an electric resonance signal at a LARMOR frequency $F = \gamma Bo$, where Bo is an ambient magnetic field into which the cell (10) is immersed and which is the field to be measured, the amplitude of the ambient magnetic field being deduced from the frequency F by the equation $Bo = F/\gamma$, this magnetometer being characterized in that the solid laser includes a sole solid element (30, 40) fulfilling both the amplitude function and the wavelength selection function.

2. Magnetometer according to claim 1, characterized in that the sole element (30) of the solid laser is an amplifier crystal (32), whose two faces (33, 34) are covered with reflecting layers and whose thickness (e) is such that the laser oscillates on a single longitudinal mode with a wavelength able to optically pump the gas (12) of the cell (10).

3. Magnetometer according to claim 1, characterized in that the sole element (40) of the solid laser is an amplifying optical fibre (42) etched over at least one portion of its length by a diffraction grating (44) with a pitch (p) and a length (L) such that the laser oscillates on a wavelength able to optically pump the gas (12) of the cell (10).

4. Magnetometer according to claim 2 or 3, characterized in that the laser includes means for low-frequency modulating the emission wavelength and means to automatically control, the wavelength at a reference control value.

5. Magnetometer according to claim 4, characterized in that the means to modulate the emission wavelength of the laser are constituted by means (50, 52, 54) able to modulate the temperature of the sole solid element.

6. Magnetometer according to claim 4, characterized in that the means to modulate the emission wavelength are constituted by means (62, 64, 72, 74, 76)

FIG. 1

FIG. 2

FIG. 3

FIG. 4

FIG. 5

FIG. 6